# FASCICULE DE BREVET EUROPEEN

(11) **EP 3 649 732 B1**
(45) Date de publication et mention de la délivrance du brevet: **28.10.2020**
(21) Numéro de dépôt: 19737855.7
(22) Date de dépôt: 12.06.2019
(51) Int. Cl.: H02S 50/15

(54) **DISPOSITIF DE TEST D'UN GENERATEUR SOLAIRE DE SATELLITE**
VORRICHTUNG ZUM TESTEN EINER SATELLITENSOLARANORDNUNG
DEVICE FOR TESTING A SATELLITE SOLAR ARRAY

(30) Priorité: 28.06.2018 FR 1855824
(43) Date de publication de la demande: 13.05.2020
(73) Titulaire: Airbus Defence and Space SAS, 31402 Toulouse Cedex 4 (FR)
(72) Inventeur: VERGNET, Dominique, 31402 TOULOUSE Cedex 4 (FR); SABATHE, Marc, 31402 TOULOUSE Cedex 4 (FR)
(74) Mandataire: Plasseraud IP
(86) Numéro de dépôt international: PCT/FR2019/051420
(87) Numéro de publication internationale: WO 2020/002791

(56) Documents cités:
- US-A- 5 955 885
- US-A1- 2016 359 454

## Description

### DOMAINE DE L'INVENTION

L'invention concerne un dispositif de test d'un générateur solaire de satellite ou de drone solaire.
Le dispositif selon l'invention est notamment utilisable pour tester la bonne santé de cellules solaires composant un générateur solaire, mais également pour tester le bon fonctionnement des connexions des cellules solaires et de leurs éléments de protection.

### ETAT DE LA TECHNIQUE

L'alimentation électrique d'un satellite est réalisée par un ou plusieurs générateurs solaires, chaque générateur comprenant une matrice de cellules solaires comprenant plusieurs jonctions p-n, et typiquement trois jonctions p-n. Les cellules solaires à triple jonction, présentant un rendement de conversion électrique plus élevées que des cellules à double jonction, bien qu'étant plus coûteuses. Le document US2016/359454A décrit des dispositifs de test d'un générateur solaire.

Compte-tenu des difficultés d'accès à un satellite une fois celui-ci déployé, il est très difficile voire impossible d'en tester ou d'en réparer des composants après son lancement, et il est donc primordial de pouvoir le tester au sol avant lancement. En particulier, les générateurs solaires font l'objet de plusieurs tests de bon fonctionnement, ayant pour but de démontrer que la performance des générateurs sera assurée une fois le satellite lancé, et si besoin, de remplacer les composants défectueux avant le lancement.

Ces tests de bon fonctionnement comprennent notamment une vérification de l'intégrité des circuits électriques et de la performance des cellules solaires qui les composent. Cette vérification est faite actuellement par une série de tests unitaires, comprenant typiquement :
- Test de continuité du câblage et des éléments de protection, de type diodes de dérivation des cellules,
- Test de bonne santé des cellules solaires,
- Test d'allocation et de bonne connexion des sections électriques au satellite après intégration du générateur solaire.

Le test de bonne santé des cellules solaires peut être réalisé par un test d'électroluminescence, qui consiste à alimenter en courant le générateur solaire, et acquérir et traiter des images d'électroluminescence générées en réponse à ce courant, pour détecter d'éventuels défauts. Il peut également être réalisé par un test dit « flash test », qui consiste à éclairer le générateur solaire et mesurer la puissance électrique et/ou la caractéristique I(V) générée en réponse.

Le test de continuité du câblage peut être mis en oeuvre manuellement en polarisant individuellement les différentes chaînes de cellules solaires composant le générateur.

Ces différents types de tests imposent de déconnecter le générateur solaire du satellite, et d'accéder au réseau électrique du générateur solaire, pour y connecter une électronique de mesure et de traitement. Compte-tenu du temps nécessaire à ces tests, le générateur solaire doit généralement être démonté du satellite et amené dans une zone spécifique pour le test, ce qui ajoute une manutention et donc des risques de dégradation du générateur solaire et du satellite indésirables compte-tenu des coûts de production de ces pièces.

Le test d'allocation peut, quant à lui, être réalisé en éclairant différentes zones du générateur solaire et en mesurant la réponse au niveau du satellite. Ce test est donc réalisé dans un deuxième temps, une fois le générateur solaire assemblé à nouveau au satellite.

La variété des différents tests mis en œuvre, et les contraintes qui s'imposent en termes de connexion au générateur solaire et de manipulation de celui-ci pour pouvoir réaliser chaque test, rendent le protocole de test long et risqué.

Les mêmes problématiques se posent également pour les drones solaires, qui du fait de leurs contraintes importantes d'intégration et de légèreté, comprennent des générateurs solaires onéreux et fragiles qu'il est important de pouvoir tester sans risque de dégradation. De plus, pour des drones solaires pouvant présenter une autonomie suffisante pour ne pas se poser la nuit, il est également avantageux de pratiquer l'ensemble des tests nécessaires avant le lancer du drone pour éviter une interruption intempestive du vol.

Il existe donc un besoin pour un moyen de test d'un générateur solaire plus rapide et qui présentent moins de risques pour l'intégrité du générateur solaire et du satellite ou du drone sur lequel il est monté.

### PRESENTATION DE L'INVENTION

Compte-tenu de ce qui précède, l'invention a pour but de pallier au moins en partie les inconvénients de l'art antérieur.

En particulier, un but de l'invention est de proposer un dispositif de test sans contact d'un générateur solaire, qui soit utilisable pour mener différents types de test.

Un autre but de l'invention est de proposer un dispositif de test à réaliser des tests de bonne santé des cellules solaires, et également des tests de continuité du câblage, et de bonne connexion des sections électriques au satellite ou au drone solaire.

A cet égard, l'invention a pour objet un dispositif de test d'un générateur solaire de satellite ou de drone solaire, le générateur solaire comprenant une matrice de cellules solaires mono-jonction ou multi-jonctions, chaque jonction étant adaptée pour convertir des photons d'une bande de longueurs d'ondes respective en courant électrique,
le dispositif de test comprenant :
- une matrice de sources lumineuses, comprenant au moins une rangée de sources lumineuses, chaque source lumineuse de la matrice étant adaptée pour émettre de la lumière dans chacune des bandes de longueurs d'ondes de conversion électrique de la ou des jonctions des cellules solaires,
- une unité de contrôle de la matrice de sources lumineuses, adaptée pour commander l'allumage et l'extinction de chacune des sources lumineuses de la matrice individuellement,
la matrice de sources lumineuses étant en outre configurée de manière à pouvoir sélectivement illuminer chaque cellule solaire du générateur solaire par l'allumage d'une ou plusieurs sources lumineuses de la matrice, avec une puissance lumineuse surfacique reçue par la cellule solaire supérieure à au moins 130W/m².

Dans un mode de réalisation, chaque cellule solaire est du type multi-jonctions, et chaque source lumineuse de la matrice comporte une pluralité de diodes électroluminescentes, chaque diode électroluminescente étant adaptée pour émettre de la lumière dans une bande de longueurs d'ondes de conversion électrique d'une jonction respective des cellules solaires.
Par exemple, N étant le nombre de jonction des cellules solaires du générateur solaire, chaque source lumineuse de la matrice peut comporter un nombre N de diodes électroluminescentes, chaque diode d'une source lumineuse étant adaptée pour émettre de la lumière dans une bande de longueurs d'ondes absorbée par une jonction respective des cellules solaires.

Dans un mode de réalisation particulier, les cellules solaires sont du type à triple jonction, et chaque source lumineuse de la matrice comporte :
- une première diode électroluminescente adaptée pour émettre de la lumière dans une bande de longueurs d'ondes centrée sur 450 nm,
- une deuxième diode électroluminescente adaptée pour émettre de la lumière dans une bande de longueurs d'ondes centrée sur 850 nm, et
- une troisième diode électroluminescente adaptée pour émettre de la lumière dans une bande de longueurs d'ondes centrée sur 940 nm.

Avantageusement, l'unité de contrôle est en outre adaptée pour commander individuellement l'allumage, l'extinction et la puissance de chaque diode électroluminescente d'une source lumineuse de la matrice.

Avantageusement, la distance entre deux sources lumineuses adjacentes de la matrice est inférieure ou égale à la distance entre les centres de deux cellules solaires adjacentes.

Dans un mode de réalisation, le dispositif de test comprend en outre une optique adaptée pour contrôler l'angle d'ouverture d'un faisceau lumineux émis par chaque source lumineuse. Dans le cas où les sources lumineuses comprennent des LEDs, cette optique peut être intégrée dans chaque LED.

Le dispositif de test peut comprendre en outre un dispositif de protection du générateur solaire, comprenant :
- un écran transparent adapté pour bloquer les rayons lumineux présentant une longueur d'onde supérieure à 1.8µm, et
- un ventilateur adapté pour faire circuler de l'air entre l'écran transparent et la matrice de sources lumineuses.
La matrice de sources lumineuses est avantageusement formée d'une pluralité de sous-matrices, chaque sous-matrice comportant au moins une rangée de sources lumineuses.

L'invention a également pour objet un procédé de test d'un générateur solaire d'un satellite ou d'un drone solaire, le générateur solaire comprenant une matrice de cellules solaires multi-jonctions, chaque jonction étant adaptée pour convertir des photons d'une bande de longueurs d'ondes respective en courant électrique, le procédé de test étant mis en oeuvre à l'aide d'un dispositif de test selon la description qui précède, et comprenant les étapes suivantes :
- positionner la matrice de sources lumineuses du dispositif de test en regard du générateur solaire,
- en allumant au moins une source lumineuse de la matrice, sélectivement illuminer au moins une cellule solaire du générateur solaire,
- mesurer un courant de réponse de la cellule solaire illuminée, et
- analyser le courant de réponse mesuré pour en déduire un état sain ou défectueux du générateur solaire.

Avantageusement, le générateur solaire est assemblé à un satellite ou un drone solaire, et le courant de réponse mesuré est un courant d'alimentation du satellite ou du drone solaire par le générateur solaire.

Dans un mode de réalisation, le générateur solaire est assemblé à un satellite, et le dispositif de test est configuré de manière à pouvoir illuminer simultanément toutes les cellules solaires du générateur solaire, le procédé comprenant une étape de test d'allumage du satellite par illumination simultanée de toutes les cellules solaires du générateur solaire.

Dans un mode de réalisation, le générateur solaire comprend une pluralité de chaines de cellules solaires, les cellules solaires d'une chaine étant connectées en série, et le procédé comprend le test d'au moins une chaine de cellules solaires, ledit test comprenant :
- l'illumination successive de groupes de cellules solaires d'une chaine, les groupes comprenant un nombre constant de cellules solaires et les groupes successivement illuminés étant décalés les uns des autres d'une cellule solaire, et
- en fonction du courant de réponse mesuré pour chaque groupe de cellules solaires illuminé, déterminer un état sain ou défectueux des cellules de la chaine et un état sain ou défectueux des contacts électriques entre les cellules de la chaine.

Chaque cellule solaire du générateur solaire peut être associée à une diode de dérivation, le test d'une chaine de cellules solaires peut alors comprendre la détermination, en fonction du courant de réponse mesuré pour chaque groupe de cellules solaires illuminé, d'un état sain ou défectueux des diodes de dérivation associées aux cellules solaires de la chaine.

Dans le cas où le générateur solaire est connecté à un régulateur, et comprend une pluralité de chaines de cellules solaires, les cellules solaires d'une chaine étant connectées en série, le procédé peut comprendre l'illumination sélective d'une ou plusieurs chaines de cellules solaires, et la détermination, en fonction du courant de réponse mesuré, d'un état sain ou défectueux du régulateur et des connexions entre les chaines et le régulateur.

Le dispositif de test selon l'invention permet de réaliser un test de bonne santé de cellules solaires d'un générateur solaire sans contact et sans interface spécifique de test. En effet, le dispositif est configuré de manière à pouvoir éclairer chaque cellule avec une puissance reçue supérieure à 130W/m², ce qui correspond au dixième de la puissance reçue du soleil dans l'espace, et qui permet de faire générer par les cellules solaires un courant suffisamment élevé pour être mesurable au niveau du satellite ou du drone.

Il n'est donc pas nécessaire de déconnecter le générateur solaire du satellite ou du drone, ce qui réduit les risques liés à la manutention ainsi que la durée du test.

De plus, la configuration de la matrice de sources lumineuses du dispositif de test permet d'illuminer individuellement une ou plusieurs cellules solaires du générateur solaire. Ceci permet non seulement de déterminer un état sain ou défectueux des cellules solaires, mais également, par une séquence appropriée d'illumination de groupes de cellules solaires, de tester l'intégrité du câblage, le bon fonctionnement des diodes de dérivation, et l'allocation, c'est-à-dire la bonne connexion du générateur solaire au satellite ou au drone.

### DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels:
- La figure 1a représente schématiquement un exemple de dispositif de test selon un mode de réalisation de l'invention,
- La figure 1b représente schématiquement un cadre de support d'une matrice de sources lumineuses,
- La figure 1c représente schématiquement une vue de profil d'une matrice de sources lumineuses montée sur un cadre,
- La figure 1d représente schématiquement un exemple de dispositif de test selon un autre mode de réalisation de l'invention,
- La figure 2a représente un exemple de source lumineuse comprenant quatre LEDs de spectres d'émission différents,
- La figure 2b représente un exemple de configuration à haute densité de LEDs,
- Les figures 3a et 3b représentent deux exemples de configuration d'une matrice de sources lumineuses d'un dispositif de test,
- La figure 4 représente schématiquement un exemple de générateur solaire de satellite,
- La figure 5 représente un exemple de caractéristique d'émission de diodes électroluminescentes d'un dispositif de test par rapport aux caractéristiques de conversion électrique des cellules solaires du générateur solaire à tester.
- La figure 6 représente schématiquement les principales étapes d'un procédé de test d'un générateur solaire selon un mode de réalisation de l'invention.

### DESCRIPTION DETAILLEE D'AU MOINS UN MODE DE REALISATION DE L'INVENTION

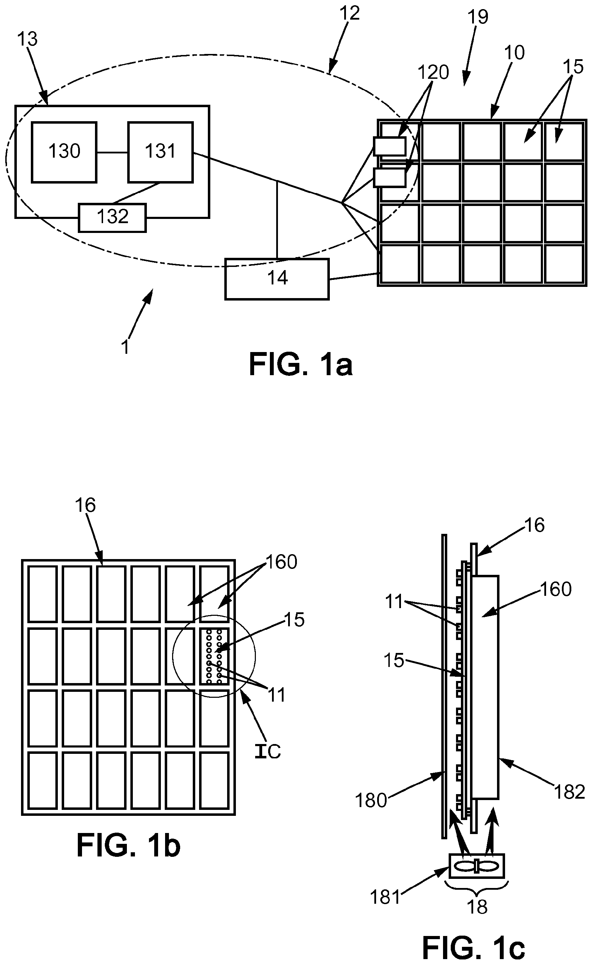

En référence à la figure 1a, on va maintenant décrire un dispositif de test 1 d'un générateur solaire permettant d'effectuer un ensemble de vérifications du bon fonctionnement du générateur solaire sans contact et manipulation du générateur solaire pour accéder à ses composants internes. Le générateur solaire est avantageusement destiné à être embarqué dans un satellite S ou un drone solaire, pour assurer l'alimentation électrique de celui-ci.

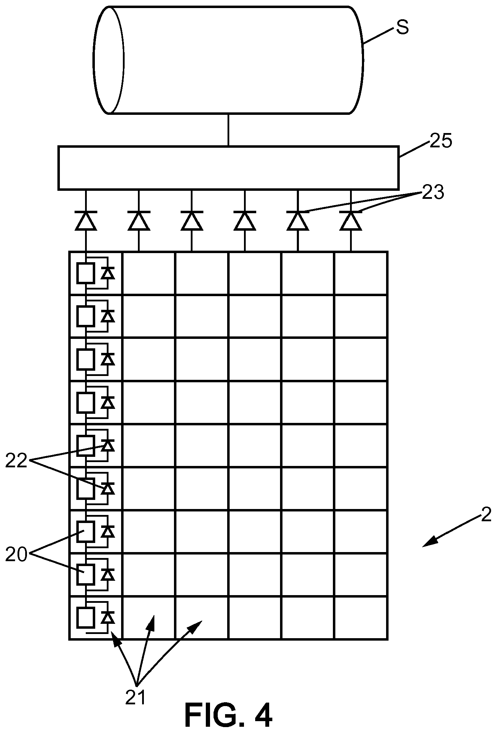

Un exemple de générateur solaire 2 est représenté schématiquement sur la figure 4. Il comprend une matrice de cellules solaires 20 comprenant au moins une jonction, et de préférence au moins deux-jonctions - on parle alors de cellules multi-jonctions - chaque jonction d'une cellule solaire étant adaptée pour convertir des photons d'une bande de longueurs d'ondes respective en courant électrique par effet photovoltaïque.

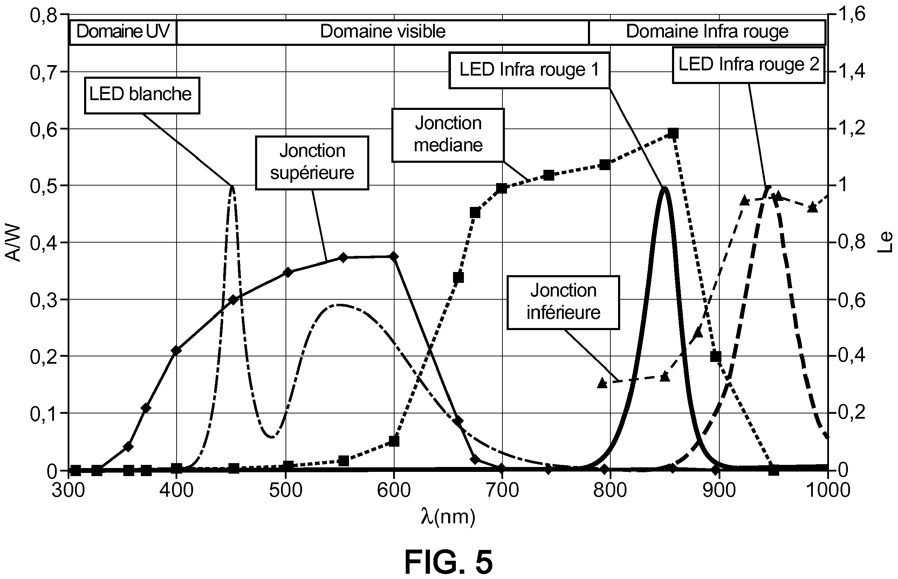

Notamment dans le cas de l'alimentation d'un satellite, les cellules solaires 20 du générateur solaire peuvent typiquement être des cellules à triple jonction, comme par exemple des cellules selon les modèles 3G28 ou 3G30 commercialisés par la société Azurspace, la réponse spectrale de cette dernière étant représentée sur la figure 5, dont l'abscisse représente les longueurs d'onde, et l'ordonnée de gauche représente le taux de conversion photoélectrique de la cellule (encore appelé External Quantum Efficiency EQE).

Par exemple, une cellule à triple jonction peut comprendre :
- une jonction supérieure, adaptée pour convertir en courant électrique des photons dans une bande de longueurs d'onde comprise entre 400 et 600 nm,
- une jonction médiane, adaptée pour convertir en courant électrique des photons d'une bande de longueurs d'ondes comprise entre 650 et 900 nm, et
- une jonction inférieure, adaptée pour convertir en courant électrique des photons dans le proche infrarouge, par exemple dans une bande de longueurs d'ondes comprise entre 900 et 1000 nm.

Par « matrice » de cellules solaires, on entend que les cellules solaires sont arrangées selon une disposition régulière, avec une distance constante entre deux cellules solaires voisines (pouvant comprendre une première distance selon une première direction et une deuxième distance selon une deuxième direction orthogonale à la première). Typiquement, les cellules solaires sont réparties en rangées comprenant toutes le même nombre de cellules. Par exemple, une matrice de cellules solaires peut présenter une forme sensiblement rectangulaire, et comprendre un nombre N ^{∗} R de cellules solaires, réparties en N rangées comprenant chacune R cellules. Dans le cas où N = R, la matrice est de forme sensiblement carrée.

Les cellules solaires 20 du générateur solaire 2 sont réparties par chaînes 21, chaque chaîne comprenant une pluralité de cellules solaires 20 connectées en série les unes aux autres. Sur la figure 4, on a représenté à titre d'exemple six chaînes de cellules solaires.

De plus, le générateur solaire 2 peut comprendre une ou plusieurs diodes de dérivation 22, également appelées diodes de bypass, une diode de dérivation étant connectée en parallèle d'une ou plusieurs cellules solaires 20 et permettant de court-circuiter la ou les cellules solaires auxquelles elle est connectée en cas d'ombrage de celle(s)-ci. Par exemple, le générateur solaire 2 peut comprendre une diode de dérivation 22 pour chaque cellule solaire, comme cela est représenté schématiquement sur la figure 4, une seule des six chaînes de cellules solaires y étant détaillée.

Le générateur solaire 2 peut également comprendre, pour chaque chaine 21, une diode de blocage de chaine 23, permettant d'empêcher le courant de circuler en sens inverse dans une chaine en cas d'ombrage.

Enfin le générateur solaire est connecté à un régulateur de de puissance 25 de type transfert direct d'énergie (appelé aussi DET en anglais) ou de suivi du point de puissance maximum (appelé aussi MPPT de l'acronyme l'anglais « Maximum Power Point Tracking ») suivant les besoins du satellite. Le courant converti par le régulateur 25 peut ensuite être utilisé pour l'alimentation du satellite S ou du drone auquel le générateur solaire est monté.

Avant le lancement du satellite ou du drone, le bon fonctionnement des générateurs solaires doit être vérifié.

De retour à la figure 1a, le dispositif de test 1 d'un générateur solaire comprend un dispositif d'éclairage 19 comportant une matrice 10 de sources lumineuses 11, où ici aussi le terme de matrice est interprété comme un ensemble de plusieurs sources lumineuses réparties selon une disposition régulière, par exemple avec une distance constante entre deux sources lumineuses adjacentes (pouvant comprendre une première distance selon une première direction et une deuxième distance selon une deuxième direction orthogonale à la première). De préférence, les sources lumineuses 11 de la matrice sont réparties en rangées comprenant toutes le même nombre de sources lumineuses. Les sources lumineuses sont disposées sur un support plan, formant ainsi un panneau d'une taille et d'une géométrie qui peuvent être configurées en fonction du générateur solaire à tester.

De plus, chaque source lumineuse 11 de la matrice 10 est adaptée pour émettre de la lumière dans au moins une des bandes de longueurs d'ondes de conversion électrique des jonctions des cellules solaires.

Dans un mode de réalisation, chaque source lumineuse 11 de la matrice 10 est adaptée pour émettre de la lumière dans chacune des bandes de longueurs d'ondes de conversion électrique des jonctions des cellules solaires.

Ceci permet, en illuminant une cellule solaire au moyen d'une source lumineuse, d'exciter simultanément toutes les jonctions de la cellule solaire, et donc de permettre la génération de courant électrique par la cellule solaire.

Par exemple, chaque source lumineuse 11 peut comprendre au moins une diode électroluminescente (appelée LED dans la suite) pour chaque jonction de la cellule solaire, chaque diode électroluminescente étant adaptée pour générer de la lumière dans une bande de longueurs d'ondes absorbée par une jonction respective de la cellule solaire.

On comprend que la nature de la source lumineuse peut varier en fonction de la nature des cellules solaires, et plus précisément les plages d'émission des LEDs peuvent varier en fonction des jonctions des cellules solaires.

A titre d'exemple non limitatif, afin d'être adaptée au moins à une cellule triple-jonction de type 3G28 dont la réponse spectrale est représentée sur la figure 5, chaque source lumineuse 11 de la matrice 10 peut avantageusement comprendre trois LEDs :
- une première LED adaptée pour émettre de la lumière dans une bande de longueurs d'ondes centrée sur 450 nm, afin d'émettre de la lumière dans la bande d'absorption de la jonction supérieure de la cellule (400-600 nm) ; c'est le cas d'une LED blanche dont le spectre d'émission est également représenté sur la figure 5,
- une deuxième LED adaptée pour émettre de la lumière dans une bande de longueurs d'ondes centrée sur 850 nm, afin d'émettre de la lumière dans la bande d'absorption de la jonction médiane de la cellule (650 - 900 nm), c'est le cas d'une première LED infrarouge dont le spectre d'émission est représenté sur la figure 5, et
- une troisième LED adaptée pour émettre de la lumière dans une bande de longueurs d'ondes centrée sur 940 nm, afin d'émettre de la lumière dans la bande d'absorption de la jonction inférieure de la cellule (900 - 1000 nm), c'est le cas de la deuxième LED infrarouge dont le spectre d'émission est représenté sur la figure 5.
Sur la figure 5, l'ordonnée de droite représente la luminance spectrale des LEDs.

En variante chaque source lumineuse 11 peut également comporter plusieurs LEDs pour chaque jonction d'une cellule solaire, par exemple deux ou trois LEDs permettant d'éclairer dans la bande de longueurs d'ondes de chaque jonction.

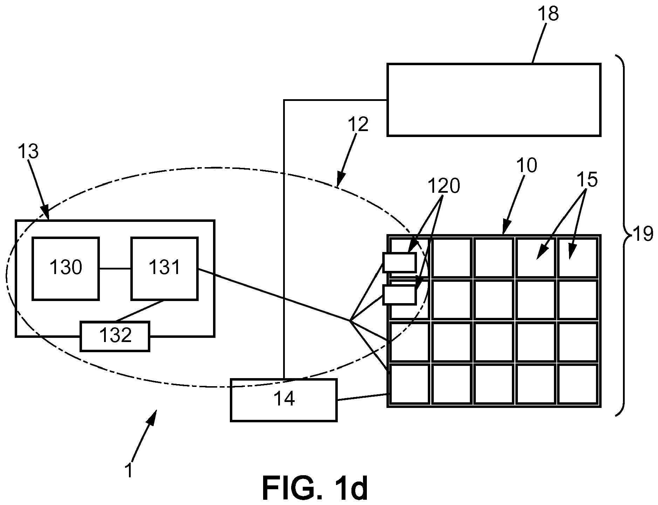

Dans un autre mode de réalisation, les sources lumineuses 11 de la matrice sont adaptées pour émettre de la lumière dans une seule bande de longueurs d'ondes de conversion électrique des cellules solaires. Dans ce cas, et comme représenté schématiquement sur la figure 1d, le dispositif d'éclairage 19 peut également comprendre, afin d'illuminer des cellules solaires à multiples jonctions, au moins une source lumineuse secondaire 18 adaptée pour émettre de la lumière dans la ou les autres bandes de longueurs d'ondes de conversion électrique des cellules solaires. Plus généralement ce cas pourrait aussi s'appliquer si les sources lumineuses 11 sont capables d'illuminer dans plus d'une bande de longueurs d'ondes, au maximum N-1 bandes de longueurs de conversion électrique des cellules solaires correspondant à N-1 jonctions, N étant le nombre de jonctions d'une cellule.

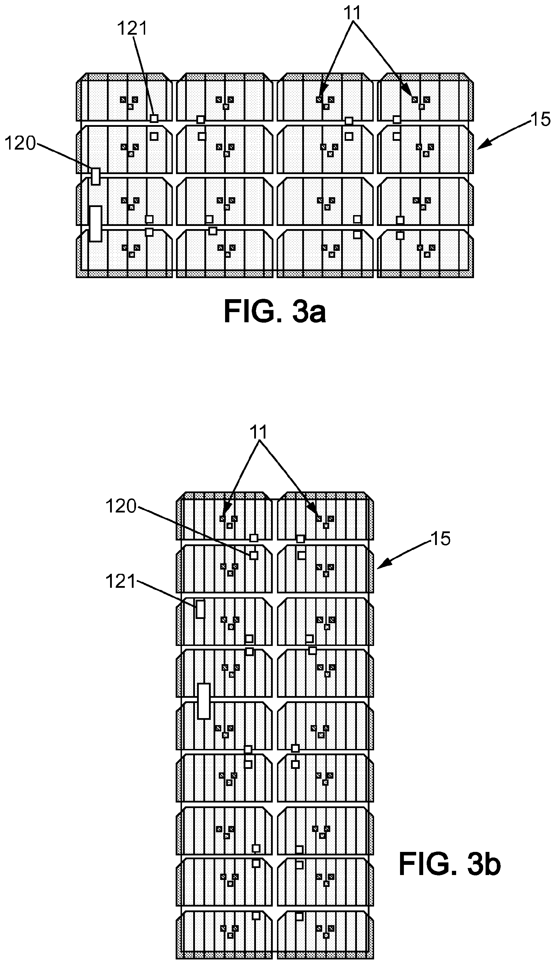

De retour à la figure 1a, le dispositif 1 de test comprend également une unité de contrôle 12 du dispositif d'éclairage. L'unité de contrôle est en particulier adaptée pour commander l'allumage et l'extinction sélectivement de chacune des sources lumineuses 11 de la matrice 10 individuellement. Avantageusement, l'unité de contrôle 12 est aussi adaptée pour contrôler la ou les sources lumineuses secondaires 18.
A cet égard, l'unité de contrôle 12 peut comprendre un ordinateur 13 comprenant :
- une mémoire 130, stockant des instructions pouvant être exécutées par un processeur,
- un processeur 131, adapté pour exécuter des instructions stockées dans la mémoire pour envoyer des commandes d'allumage ou d'extinction aux sources lumineuses, et
- une interface homme/machine 132, comprenant par exemple un écran, éventuellement tactile, pour afficher des informations relatives à l'état allumé ou éteint des sources, et des moyens de saisie de commande d'un opérateur, pour commander l'allumage ou l'extinction des sources.
L'unité de contrôle 12 peut également comprendre, en référence aux figures 3a et 3b, au moins un microcontrôleur 120 connecté à un sous-ensemble respectif de sources lumineuses de la matrice 10 et adapté pour convertir les commandes du processeur en instructions pour le pilotage des sources lumineuses. L'unité de contrôle 12 peut enfin comprendre, pour chaque source lumineuse, un transistor de puissance basse tension 121 adapté pour recevoir les instructions du microncontrôleur et pour sélectivement commuter en fonction des instructions pour alimenter ou non les sources.
Avantageusement, l'unité de contrôle 12 peut également être adaptée pour commander et faire varier la puissance émise par les sources lumineuses respectivement dans chaque bande de longueurs d'ondes correspondant à une jonction respective d'une cellule solaire. Ainsi, dans le cas où les sources lumineuses comprennent au moins une LED par jonction d'une cellule solaire, l'unité de contrôle 12 est avantageusement adaptée pour contrôler individuellement l'allumage, l'extinction, et la puissance d'émission lumineuse de chaque LED.

Enfin de retour à la figure 1a, le dispositif de test 1 comprend en outre une alimentation de puissance 14 de la matrice 10 de sources lumineuses et le cas échéant de la ou des sources secondaires 18. Cette alimentation convertit la tension du secteur (220V mono ou triphasé par exemple) en tension adaptée aux matrices. Le choix de la tension est déterminé pour minimiser le courant d'alimentation des matrices et peut typiquement être sélectionné entre 10 et 40V.

Le dispositif d'éclairage est donc adapté pour pouvoir illuminer chaque cellule solaire du générateur solaire dans chaque bande de longueurs d'ondes correspondant à une jonction de la cellule, et il est adapté pour permettre un éclairage commutable individuellement pour chaque cellule solaire pour au moins l'une des jonctions, afin de pouvoir faire commuter sélectivement chaque cellule entre un état où elle ne délivre pas de courant (au moins une jonction n'est pas illuminée) et un état où, en fonctionnement normal, elle délivre du courant (toutes les jonctions sont illuminées).

En effet, dans le cas où les sources lumineuses 11 de la matrice 10 sont adaptées pour émettre de la lumière dans les bandes de longueurs d'ondes correspondant à chacune des jonctions des cellules solaires, la commutation de chaque source lumineuse permet de passer d'un état à l'autre pour chaque cellule.

Dans le cas où les sources lumineuses 11 n'éclairent que dans une bande de longueurs d'ondes, avec des cellules solaires à multiples jonctions, et où le dispositif d'éclairage 19 comprend en outre une ou des sources lumineuses secondaires 18 pour les autres jonctions, il suffit d'éclairer le générateur solaire avec la ou les sources secondaires 18 et de faire commuter les sources lumineuses de la matrice 10 pour activer la jonction manquante et ainsi commuter d'un état à l'autre pour chaque cellule.

De plus, le dispositif d'éclairage est adapté pour éclairer les cellules solaires avec une puissance lumineuse surfacique reçue par la cellule solaire supérieure ou égale à au moins 130W/m², qui correspond à la puissance cumulée dans toutes les bandes de longueurs d'ondes correspondant à toutes les jonctions

Ceci permet d'assurer que, lorsqu'une cellule solaire est illuminée, elle l'est avec une puissance lumineuse suffisante pour causer la génération par la cellule solaire d'un courant électrique mesurable, ceci permettant donc d'évaluer, par l'analyse du courant de réponse, si la cellule solaire illuminée est fonctionnelle ou non. Cette puissance lumineuse correspond également à environ un dixième de la puissance lumineuse reçue du soleil par les cellules solaires d'un générateur solaire de satellite en utilisation dans l'espace.

Pour permettre une commutation individuelle de chaque cellule, la matrice 10 de sources lumineuses comprend de préférence au moins autant de sources lumineuses que le générateur solaire comprend de cellules solaires, de sorte qu'au moins une source lumineuse corresponde à une cellule solaire donnée, et que l'allumage de la source cause l'illumination de la cellule correspondante.

En d'autres termes, la distance entre deux sources lumineuses est inférieure ou égale à la distance entre les centres de deux cellules solaires du générateur solaire.

En variante, la matrice 10 de sources lumineuses peut comporter des sources lumineuses en nombre multiple du nombre de cellules solaires du générateur.

De plus, plus la densité surfacique de sources lumineuses de la matrice 10 est importante, et plus le dispositif de test peut être adapté à une diversité de types de générateurs solaires, puisqu'alors on peut regrouper les sources lumineuses selon des configurations variables en fonction du générateur solaire à tester.

Par exemple, les générateurs solaires classiquement utilisés pour les satellites présentent une densité de cellules solaires telle que la distance entre les centres deux cellules solaires adjacents est typiquement comprise entre 4 et 14cm. Avantageusement, la matrice de sources lumineuses du dispositif de test peut présenter une densité de sources lumineuses plus importante que la densité des cellules solaires, correspondant à une distance entre deux sources lumineuses adjacentes de moins de 5 cm, de préférence moins de 1 cm, par exemple de 5mm.

On comprend, dans le cas où le dispositif d'éclairage 19 comprend aussi une ou des sources lumineuses secondaires 18, que les exigences en matière d'éclairage individuel de chaque cellule solaire ne s'appliquent qu'à la matrice 10 de sources lumineuses 11 puisque c'est cette matrice 10 qui permet une commutation individuelle des cellules, et que la ou les sources lumineuses secondaires peuvent être plus grossières pour un éclairage plus diffus. Ainsi chaque source lumineuse secondaire pourrait couvrir plusieurs cellules, voire le générateur complet.

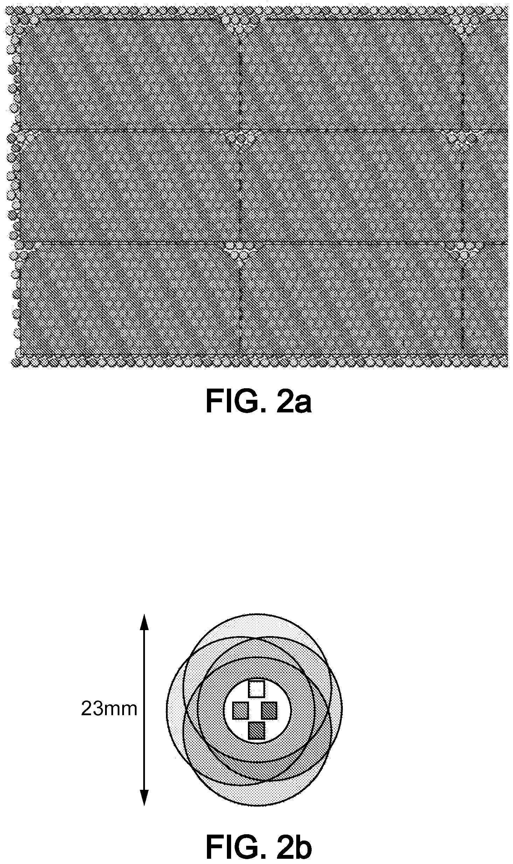

Pour atteindre des densités surfaciques importantes de sources lumineuses, on privilégiera l'utilisation de boîtiers dans lesquels les LEDS sont juxtaposées ou superposées, et dans lesquels chaque LEDs comporte une optique intégrée pour réduire l'ouverture angulaire du faisceau émis à 10° ou moins. On a représenté en figure 2a un exemple d'une source lumineuse adaptée à des cellules à quatre jonctions, comprenant quatre LEDs dont les bandes d'émission sont respectivement centrées sur quatre longueurs d'ondes différentes, les quatre LEDs étant montées sur une carte commune et chaque LEDs comprenant une optique intégrée permettant de réduire l'ouverture angulaire du faisceau à 10°. A 10 cm de distance, le faisceau généré par l'exemple représenté présente un diamètre de 23 mm et permet donc d'illuminer significativement une seule cellule du générateur.

En variante, on a représenté en figure 2b un exemple de matrice à haute densité comprenant des rangées de LEDs adaptées à quatre jonctions de cellules solaires, les rangées de LEDs étant organisées de manière compacte. Sur l'exemple représenté, le pas entre deux LEDs adjacentes est de 4 mm dans la direction horizontale et dans la direction définie par une rangée. On peut donc regrouper les LEDs pour illuminer individuellement une cellule d'un générateur solaire selon des configurations variables en fonction de la configuration des cellules solaires.

Dans un mode de réalisation, la matrice 10 de sources lumineuses comprend une pluralité de sous-matrices 15 pouvant être assemblées les unes aux autres, chaque sous-matrice 15 pouvant être individuellement alimentée et raccordée à l'ordinateur 13. A cette égard, chaque sous matrice comprend alors un microcontrôleur 120 permettant de commander l'ensemble des sources lumineuses de la sous-matrice.

Chaque sous-matrice 15 comprend au moins une, et de préférence plusieurs sources lumineuses 11. Avantageusement, une sous-matrice 15 comporte au moins une rangée de sources lumineuses 11.

Avantageusement, le dispositif de test 1 comprend en outre un cadre 16, représenté schématiquement sur la figure 1b, et permettant l'assemblage des sous-matrices pour former une matrice de géométrie voulue. Le cadre peut par exemple comprendre un ensemble de d'emplacements 160, chaque emplacement étant adapté pour recevoir une sous-matrice, par exemple par vissage ou boulonnage ou encliquetage.

Cette organisation en sous-matrices permet de rendre le dispositif de test modulable en fonction de la géométrie du générateur solaire à tester. En effet, on peut alors sélectionner un nombre de sous-matrices adapté, et les assembler selon une configuration déterminée en fonction de ladite géométrie.

Sur les figures 3a et 3b, on a représenté deux exemples possibles de sous-matrices. Dans un premier mode de réalisation représenté sur la figure 3a, une sous-matrice comporte 4 rangées de 4 sources lumineuses 11. En variante représentée sur la figure 3b, une sous-matrice comporte 2 rangées de 9 sources lumineuses 11.

En outre, afin de pouvoir sélectivement illuminer une cellule solaire 20 sur au moins une bande de longueurs d'ondes correspondant à une jonction, le dispositif de test comprend avantageusement une optique (non représentée) permettant de contrôler, et avantageusement de réduire, l'angle d'ouverture du faisceau lumineux émis par chaque source 11. Cette optique peut par exemple comprendre une ou plusieurs lentille(s), et/ou un ou plusieurs diaphragme(s). Comme déjà décrit ci-avant, l'optique peut également être intégrée directement sur les LED pour permettre l'augmentation de la densité des LEDs.

La valeur de l'angle d'ouverture maximal à ne pas excéder dépend d'autres paramètres dont notamment la distance entre les cellules solaires et les sources lumineuses. Typiquement, cette distance est de préférence supérieure à 5 cm, car en-dessous il existe un risque de contact, et donc de dégradation, du générateur solaire par le dispositif de test. Cette distance est de préférence inférieure à 15 à 20 cm, car au-delà il existe un risque d'éblouissement des opérateurs travaillant à proximité du dispositif de test.

Par exemple, la distance entre les cellules solaires et les sources lumineuses peut être égale à 10 cm, et l'optique de contrôle de l'angle d'ouverture peut être adaptée pour réduire l'angle d'ouverture du faisceau lumineux à un angle inférieur à 15°, par exemple égal à 10°.

La puissance reçue par les cellules solaires dépend également de la densité des sources lumineuses, de la puissance émise par les sources lumineuses, de la distance et de l'angle d'ouverture du faisceau lumineux. Dans un mode de réalisation dans lequel il y a une source lumineuse par cellule solaire du générateur solaire, chaque source étant adaptée pour générer de la lumière dans chaque bande de longueurs d'ondes correspondant à une jonction d'une cellule, et chaque source 11 étant, en test, placée à une distance comprise entre 5 et 15 cm du générateur solaire et présentant un degré d'ouverture inférieur à 15°, la source lumineuse est avantageusement configurée pour générer une puissance de 1 à 2 Watts pour 10 cm².

Compte-tenu de la puissance reçue par le générateur solaire, le dispositif de test 1 comprend avantageusement un dispositif de protection 18 du générateur solaire. Ce dispositif de protection 18 comprend avantageusement un écran transparent 180 s'étendant entre les sources lumineuses 11 de la matrice et les cellules solaires, adapté pour apporter à la fois une protection mécanique, en cas de défaillance des sources lumineuses (protection, confinement de la pollution générée), et thermique. A cet égard, l'écran transparent 180 est avantageusement adapté pour bloquer les rayons infrarouges de longueur d'onde supérieure à 1.8 µm afin de limiter l'échauffement du générateur solaire. En référence à la figure 1c, cet écran transparent 180 peut être monté sur le cadre 16, à une distance de celui-ci permettant de positionner la matrice 10 de sources lumineuses tout en maintenant un espace entre les sources lumineuses et l'écran permettant la circulation de l'air.

A cet égard le dispositif de protection 18 peut également comprendre un ventilateur 181 adapté pour renouveler l'air dans l'espace entre les sources lumineuses et l'écran 180. Enfin, le dispositif de protection 18 peut également comprendre un radiateur 182 sur la face arrière de la matrice de sources lumineuses, c'est-à-dire la face de la matrice orientée à l'opposé du générateur solaire, le radiateur 182 étant adapté pour évacuer la chaleur produite par les sources, et contribuant ainsi à la protection thermique du générateur solaire.

Avantageusement, mais facultativement, chaque source lumineuse 11 de la matrice 10 peut également être orientable, pour pouvoir être adaptée à plusieurs géométries de générateur solaire et permettre une illumination la plus précise possible de cellules solaires individuelles.

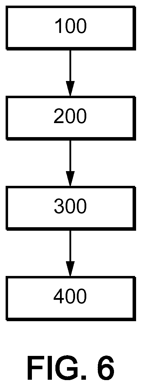

Le dispositif de test 1 décrit ci-avant permet, selon son utilisation, de réaliser plusieurs vérifications de bon fonctionnement du générateur solaire.
En référence à la figure 6, un procédé de test d'un générateur solaire à l'aide du dispositif de test décrit ci-avant comprend le positionnement 100 de la matrice de sources lumineuses en regard de la matrice de cellules solaires du générateur solaire.
Avantageusement, le dispositif de test a été préalablement configuré en fonction du générateur solaire à tester, tant par le nombre et de disposition des sources lumineuses, que par la nature et les spectres d'émission des sources lumineuses. Par exemple, dans le cas où la matrice de sources lumineuses est composée de sous-matrices, le dispositif de test a été configuré en sélectionnant le nombre et la disposition des sous-matrices permettant de tester l'ensemble du générateur solaire, et en les assemblant selon cette configuration.
De plus, la matrice 10 de sources lumineuses, et de préférence le cadre 16 sur lequel est montée la matrice, sont avantageusement fixés à un chariot mobile (non représenté), comprenant avantageusement des moyens de réglage de la position et de l'orientation de la matrice 10 de sources lumineuses montée sur celui-ci. On peut donc monter la matrice 10 de sources lumineuses sur le chariot, puis amener le chariot auprès du générateur solaire et procéder aux réglages pour positionner les sources lumineuses en regard des cellules solaires.
Avantageusement, la matrice de sources lumineuses est positionnée de sorte qu'au moins une source lumineuse se trouve en regard de chaque cellule solaire, à une distance inférieure à 20 cm, et de préférence inférieure à 15 cm, mais supérieure à 5cm.

Puis le procédé comprend l'illumination 200 d'au moins une cellule solaire du générateur solaire sur l'ensemble des bandes de longueurs d'ondes correspondant à la ou aux jonctions de la cellule solaire, par l'allumage d'au moins une source lumineuse 11 de la matrice, et le cas échéant de la source secondaire. Divers modes de réalisation de cette étape seront décrits ci-après.
Dans le cas où le dispositif d'éclairage ne comporte que la matrice 10 de sources lumineuses 11, cette étape est mise en oeuvre en allumant une ou plusieurs sources lumineuses pour correspondre à la ou aux cellules dont on souhaite activer la génération de courant.

Dans le cas où le dispositif d'éclairage comporte une ou des sources secondaires, cette étape comprend l'allumage de la source secondaire pour illuminer au moins la ou les cellules dont on souhaite activer la génération de courant, et l'allumage d'une ou plusieurs sources lumineuses 11 de la matrice correspondant à la ou les cellules, l'allumage des sources 11 pour permettre la commutation des cellules.
Le procédé comprend ensuite la mesure 300 d'un courant de réponse de la ou des cellules solaires illuminées. Le courant de réponse mesuré est de préférence le courant d'alimentation du satellite ou du drone, car il est possible d'accéder à ce courant sans accéder aux connexions électriques internes du générateur solaire (par exemple les connexions entre deux cellules ou deux chaînes), et donc cela minimise les risques de dégradation par manipulation du générateur solaire.
Le courant de réponse mesuré est ensuite analysé au cours d'une étape 400, par un opérateur ou par un algorithme mis en oeuvre par un processeur, pour en déduire un état sain ou défectueux du générateur solaire. L'analyse mise en oeuvre dépend du type d'illumination mis en œuvre et de la nature du test qui est réalisé. Elle peut par exemple, mais non limitativement, comprendre la comparaison d'une valeur de courant mesuré à un seuil déterminé en fonction du nombre de cellules illuminés, et la détection d'un dysfonctionnement si le courant mesuré est inférieur audit seuil.

Les satellites sont parfois dotés d'une fonctionnalité de démarrage automatique si le courant d'alimentation généré par les générateurs solaires dépasse un seuil prédéterminé (correspondant à un éclairage par le soleil, au moins partiel, des générateurs solaires).
Dans un mode de réalisation, cette fonctionnalité peut être testée, ainsi que la bonne connexion du générateur solaire au satellite, en allumant simultanément l'ensemble des sources lumineuses pour illuminer la totalité du générateur solaire.

En variante, le procédé comprend l'illumination sélective 200 d'une chaine de cellules, par illumination simultanée de toutes les cellules de la chaine, et l'analyse du courant de sortie permet de vérifier la bonne connexion de la chaine au satellite ou au drone, l'intégrité du câblage, la bonne allocation de la chaine à une voie du régulateur 25 qui doit lui correspondre, le bon fonctionnement du régulateur, ainsi que le bon fonctionnement diode de blocage de chaine correspondante.

De plus, si le régulateur délivre une mesure de la tension d'entrée de la chaîne, une panne de type court-circuit d'une diode de dérivation de la chaîne induit une réduction de la tension de circuit ouvert de cette chaîne.

En variante, si le régulateur est de type MPPT, le procédé peut comprendre une illumination 200 simulant un ombrage d'une partie du générateur solaire, afin de vérifier le bon fonctionnement du régulateur MPPT. On vérifie alors que la puissance du courant d'alimentation du satellite est la puissance maximale compte-tenu des cellules ombragées.

Le procédé peut également comprendre l'illumination 200 successive de groupes de cellules solaires d'une chaine, les groupes comprenant un nombre constant de cellules solaires et les groupes successivement illuminés étant décalés les uns des autres d'une seule cellule solaire, cette illumination formant un balayage progressif de la chaine.
L'évolution du courant pendant ce balayage permet de détecter un dysfonctionnement d'une cellule ou de la diode de dérivation correspondante, ou encore un contact électrique défectueux entre les cellules de la chaine.
Par exemple, si le courant est constant lors du balayage mais subit une diminution localisée, alors on peut en déduire un dysfonctionnement de la cellule ou de la diode de dérivation ajoutée en dernier au niveau du groupe correspondant à la diminution de courant.

Un test complémentaire peut permettre de distinguer si le dysfonctionnement provient de la cellule ou de la diode de dérivation associée : ce test comprend l'illumination d'abord de la cellule disposée en amont de celle où se trouve le dysfonctionnement, puis de celle-ci, et l'analyse du courant pour chaque cellule illuminée. Si lorsqu'on éclaire la cellule disposée en amont, aucun courant n'est mesurable, et lorsqu'on éclaire la cellule suivante un courant est détecté, alors on peut en déduire que la diode de bypass est défectueuse et se trouve en circuit ouvert.
En revanche si lorsqu'on éclaire la cellule disposée en amont, on détecte un courant, et que ce courant diminue lorsqu'on éclaire la cellule suivante, alors on peut en déduire que la cellule est défectueuse ou que la diode de dérivation est en court-circuit.

Ainsi, le dispositif de test présenté ci-avant permet de réaliser un ensemble de tests sur un générateur solaire sans manipulation ni contact du générateur solaire, ce qui réduit les risques d'endommager. De plus, la sollicitation individuelle des cellules solaires permet de tester le fonctionnement de cellules ou de chaines identifiées, ce qui permet de détecter avec précision la localisation d'un défaut.

## Revendications

1. Dispositif de test (1) d'un générateur solaire (2) de satellite ou de drone solaire, le générateur solaire (2) comprenant une matrice de cellules solaires (20) mono-jonction ou multi-jonctions, chaque jonction étant adaptée pour convertir des photons d'une bande de longueurs d'ondes respective en courant électrique,
le dispositif de test (1) comprenant :
- un dispositif d'éclairage (19) adapté pour émettre de la lumière dans chacune des bandes de longueurs d'ondes de conversion électrique de la ou des jonctions des cellules solaires, le dispositif d'éclairage comportant une matrice (10) de sources lumineuses (11), comprenant au moins une rangée de sources lumineuses (11), chaque source lumineuse (11) de la matrice étant adaptée pour émettre de la lumière dans au moins une bande de longueurs d'ondes de conversion électrique de la ou des jonctions des cellules solaires (20),
- une unité de contrôle (12) de la matrice (10) de sources lumineuses, adaptée pour commander l'allumage et l'extinction de chacune des sources lumineuses (11) de la matrice individuellement,
la matrice (10) de sources lumineuses (11) étant en outre configurée de manière à pouvoir sélectivement illuminer chaque cellule solaire (20) du générateur solaire par l'allumage d'une ou plusieurs sources lumineuses (11) de la matrice,
et le dispositif d'éclairage étant configuré pour pouvoir éclairer chaque cellule solaire (20) du générateur solaire avec une puissance lumineuse surfacique reçue par la cellule solaire supérieure à au moins 130W/m².

2. Dispositif de test (1) selon la revendication 1, dans lequel chaque cellule solaire (20) est du type multi-jonctions, et chaque source lumineuse (11) de la matrice (10) est adaptée pour émettre de la lumière dans chacune des bandes de longueurs d'ondes de conversion électrique de la ou des jonctions des cellules solaires (20).

3. Dispositif de test (1) selon la revendication 2, dans lequel chaque source lumineuse (11) de la matrice (10) comporte une pluralité de diodes électroluminescentes, chaque diode électroluminescente étant adaptée pour émettre de la lumière dans une bande de longueurs d'ondes de conversion électrique d'une jonction respective des cellules solaires.

4. Dispositif de test (1) selon la revendication 3, dans lequel, N étant le nombre de jonction des cellules solaires (20) du générateur solaire (2), et dans lequel chaque source lumineuse (11) de la matrice comporte un nombre n de diodes électroluminescentes, chaque diode d'une source lumineuse est adaptée pour émettre de la lumière dans une bande de longueurs d'ondes absorbée par une jonction respective des cellules solaires.

5. Dispositif de test (1) selon la revendication précédente, dans lequel les cellules solaires (20) sont du type à triple jonction, et chaque source lumineuse (11) de la matrice (10) comporte :
- une première diode électroluminescente adaptée pour émettre de la lumière dans une bande de longueurs d'ondes centrée sur 450nm,
- une deuxième diode électroluminescente adaptée pour émettre de la lumière dans une bande de longueurs d'ondes centrée sur 850 nm, et
- une troisième diode électroluminescente adaptée pour émettre de la lumière dans une bande de longueurs d'ondes centrée sur 940 nm.

6. Dispositif de test (1) selon l'une des revendications 2 à 4, dans lequel l'unité de contrôle (12) est en outre adaptée pour commander individuellement l'allumage, l'extinction et la puissance de chaque diode électroluminescente d'une source lumineuse (11) de la matrice.

7. Dispositif de test (1) selon la revendication 1, dans lequel chaque cellule solaire est du type multi-jonctions, et chaque source lumineuse (11) de la matrice est adaptée pour émettre de la lumière dans seule bande de longueurs d'ondes de conversion électrique d'une jonction des cellules solaires, et le dispositif d'éclairage comporte en outre au moins une source lumineuse secondaire adaptée pour émettre de la lumière dans chacune des autres bandes de longueurs d'ondes de conversion électrique des jonctions des cellules solaires.

8. Dispositif de test (1) selon l'une des revendications précédentes, dans lequel la distance entre deux sources lumineuses (11) adjacentes de la matrice est inférieure ou égale à la distance entre les centres deux cellules solaires (20) adjacentes.

9. Dispositif de test (1) selon l'une des revendications précédentes, comprenant en outre une optique adaptée pour contrôler l'angle d'ouverture d'un faisceau lumineux émis par chaque source lumineuse.

10. Dispositif de test (1) selon l'une des revendications précédentes, comprenant en outre un dispositif de protection (18) du générateur solaire, comprenant :
- un écran transparent (180) adaptée pour bloquer les rayons lumineux présentant une longueur d'onde supérieure à 1.8µm, et
- un ventilateur (181) adapté pour faire circuler de l'air entre l'écran transparent et la matrice de sources lumineuses.

11. Dispositif de test (1) selon l'une des revendications précédentes, dans lequel la matrice (10) de sources lumineuses (11) est formée d'une pluralité de sous-matrices(15), chaque sous-matrice (15) comportant au moins une rangée de sources lumineuses (11).

12. Procédé de test d'un générateur solaire (2) d'un satellite (S) ou d'un drone solaire, le générateur solaire (2) comprenant une matrice de cellules solaires (20) mono-jonction ou multi-jonctions, chaque jonction étant adaptée pour convertir des photons d'une bande de longueurs d'ondes respective en courant électrique, le procédé de test étant mis en œuvre à l'aide d'un dispositif de test (1) selon l'une des revendications précédentes, et comprenant les étapes suivantes :
- positionner (100) la matrice (10) de sources lumineuses (11) du dispositif de test en regard du générateur solaire,
- en allumant au moins une source lumineuse de la matrice, sélectivement illuminer (200) au moins une cellule solaire du générateur solaire dans toutes les bandes de longueurs d'ondes de conversion électrique de chaque jonction de la cellule solaire,
- mesurer (300) un courant de réponse de la cellule solaire illuminée, et
- analyser (400) le courant de réponse mesuré pour en déduire un état sain ou défectueux du générateur solaire.

13. Procédé selon la revendication 12, dans lequel le générateur solaire est assemblé à un satellite ou un drone solaire, et le courant de réponse mesuré est un courant d'alimentation du satellite ou du drone solaire par le générateur solaire.

14. Procédé selon l'une des revendications 12 ou 13, dans lequel le générateur solaire est assemblé à un satellite, et le dispositif de test est configuré de manière à pouvoir illuminer simultanément toutes les cellules solaires du générateur solaire, le procédé comprenant une étape de test d'allumage du satellite par illumination simultanée de toutes les cellules solaires du générateur solaire.

15. Procédé selon l'une des revendications 12 à 14, dans lequel le générateur solaire comprend une pluralité de chaines (21) de cellules solaires (20), les cellules solaires (20) d'une chaine (21) étant connectées en série,
le procédé comprenant le test d'au moins une chaine (21) de cellules solaires, ledit test comprenant :
- l'illumination (200) successive de groupes de cellules solaires d'une chaine, les groupes comprenant un nombre constant de cellules solaires et les groupes successivement illuminés étant décalés les uns des autres d'une cellule solaire, et
- en fonction du courant de réponse mesuré pour chaque groupe de cellules solaires illuminé, déterminer (400) un état sain ou défectueux des cellules de la chaine et un état sain ou défectueux des contacts électriques entre les cellules de la chaine.

16. Procédé selon la revendication précédente, dans lequel chaque cellule solaire du générateur solaire est associée à une diode de dérivation (22), et le test d'une chaine (21) de cellules solaires comprend en outre la détermination (400), en fonction du courant de réponse mesuré pour chaque groupe de cellules solaires illuminé, d'un état sain ou défectueux des diodes de dérivation (22) associées aux cellules solaires (20) de la chaine (21).

17. Procédé selon l'une des revendications 12 à 16, dans lequel le générateur solaire (2) est connecté à un régulateur (25), et comprend une pluralité de chaines (21) de cellules solaires (20), les cellules solaires d'une chaine étant connectées en série, et le procédé comprend l'illumination (200) sélective d'une ou plusieurs chaines (21) de cellules solaires, et la détermination (400), en fonction du courant de réponse mesuré, d'un état sain ou défectueux du régulateur et des connexions entre les chaines (21) et le régulateur (25).

## Patentansprüche

1. Vorrichtung zum Testen (1) eines Satelliten- oder Solardrohnensolargenerators (2), wobei der Solargenerator (2) eine Matrix von Solarzellen (20) mit einem Übergang oder mit mehreren Übergängen aufweist, wobei jeder Übergang eingerichtet ist, Photonen eines jeweiligen Wellenlängenbands in elektrischen Strom umzuwandeln,
wobei die Testvorrichtung (1) aufweist:
- eine Beleuchtungsvorrichtung (19), die eingerichtet ist, in jedem Wellenlängenband zur Stromumwandlung von dem oder den Übergängen der Solarzellen Licht abzugeben, wobei die Beleuchtungsvorrichtung eine Matrix (10) von Lichtquellen (11) aufweist, die mindestens eine Reihe von Lichtquellen (11) aufweist, wobei jede Lichtquelle (11) der Matrix eingerichtet ist, in mindestens einem Wellenlängenband zur Stromumwandlung von dem oder den Übergängen der Solarzellen (20) Licht abzugeben,
- eine Steuereinheit (12) der Matrix (10) von Lichtquellen, die eingerichtet ist, das Einschalten und das Ausschalten von jeder der Lichtquellen (11) der Matrix einzeln zu steuern,
wobei die Matrix (10) von Lichtquellen (11) ferner derart ausgebildet ist, dass durch das Einschalten von einer oder von mehreren Lichtquellen (11) der Matrix jede Solarzelle (20) des Solargenerators selektiv beleuchtet werden kann,
und wobei die Beleuchtungsvorrichtung derart ausgebildet ist, dass jede Solarzelle (20) des Solargenerators mit einer von der Solarzelle aufgenommenen Bestrahlungsstärke von mehr als mindestens 130 W/m² beleuchtet werden kann.

2. Testvorrichtung (1) nach Anspruch 1, wobei jede Solarzelle (20) vom Typ mit mehreren Übergängen ist, und jede Lichtquelle (11) der Matrix (10) eingerichtet ist, in jedem der Wellenlängenbänder zur Stromumwandlung von dem oder den Übergängen der Solarzellen (20) Licht abzugeben.

3. Testvorrichtung (1) nach Anspruch 2, wobei jede Lichtquelle (11) der Matrix (10) eine Vielzahl von Leuchtdioden aufweist, wobei jede Leuchtdiode eingerichtet ist, in einem Wellenlängenband zur Stromumwandlung von einem jeweiligen Übergang der Solarzellen Licht abzugeben.

4. Testvorrichtung (1) nach Anspruch 3, wobei N die Anzahl der Übergänge der Solarzellen (20) des Solargenerators (2) ist, und wobei jede Lichtquelle (11) der Matrix eine Anzahl n an Leuchtdioden aufweist, wobei jede Diode einer Lichtquelle eingerichtet ist, in einem Wellenlängenband Licht abzugeben, das von einem jeweiligen Übergang der Solarzellen absorbiert wird.

5. Testvorrichtung (1) nach dem vorhergehenden Anspruch, wobei die Solarzellen (20) vom Typ mit drei Übergängen sind und jede Lichtquelle (11) der Matrix (10) aufweist:
- eine erste Leuchtdiode, die eingerichtet ist, in einem Wellenlängenband Licht abzugeben, dessen Mittelpunkt bei 450 nm liegt,
- eine zweite Leuchtdiode, die eingerichtet ist, in einem Wellenlängenband Licht abzugeben, dessen Mittelpunkt bei 850 nm liegt, und
- eine dritte Leuchtdiode, die eingerichtet ist, in einem Wellenlängenband Licht abzugeben, dessen Mittelpunkt bei 940 nm liegt.

6. Testvorrichtung (1) nach einem der Ansprüche 2 bis 4, wobei die Steuereinheit (12) ferner eingerichtet ist, einzeln das Einschalten, das Ausschalten und die Leistung jeder Leuchtdiode einer Lichtquelle (11) der Matrix zu steuern.

7. Testvorrichtung (1) nach Anspruch 1, wobei jede Solarzelle vom Typ mit mehreren Übergängen ist, und jede Lichtquelle (11) der Matrix eingerichtet ist, in einem einzigen Wellenlängenband zur Stromumwandlung von einem Übergang der Solarzellen Licht abzugeben, und die Beleuchtungsvorrichtung ferner mindestens eine sekundäre Lichtquelle aufweist, die eingerichtet ist, in jedem der anderen Wellenlängenbänder zur Stromumwandlung der Übergänge der Solarzellen Licht abzugeben.

8. Testvorrichtung (1) nach einem der vorhergehenden Ansprüche, wobei der Abstand zwischen zwei benachbarten Lichtquellen (11) der Matrix kleiner oder gleich dem Abstand zwischen den Mittelpunkten von zwei benachbarten Solarzellen (20) ist.

9. Testvorrichtung (1) nach einem der vorhergehenden Ansprüche, ferner aufweisend eine Optik, die eingerichtet ist, den Öffnungswinkel eines Lichtbündels zu steuern, das von jeder Lichtquelle abgegeben wird.

10. Testvorrichtung (1) nach einem der vorhergehenden Ansprüche, ferner aufweisend eine Schutzvorrichtung (18) des Solargenerators, welche aufweist:
- eine transparente Abschirmung (180), die eingerichtet ist, die Lichtstrahlen zu blockieren, die eine Wellenlänge über 1,8 µm aufweisen, und
- einen Ventilator (181), der eingerichtet ist, Luft zwischen der transparenten Abschirmung und der Matrix von Lichtquellen zirkulieren zu lassen.

11. Testvorrichtung (1) nach einem der vorhergehenden Ansprüche, wobei die Matrix (10) von Lichtquellen (11) aus einer Vielzahl von Untermatrizen (15) gebildet ist, wobei jede Untermatrix (15) mindestens eine Reihe von Lichtquellen (11) aufweist.

12. Verfahren zum Testen eines Solargenerators (2) eines Satelliten (S) oder einer Solardrohne, wobei der Solargenerator (2) eine Matrix von Solarzellen (20) mit einem Übergang oder mit mehreren Übergängen aufweist, wobei jeder Übergang eingerichtet ist, Photonen eines jeweiligen Wellenlängenbands in elektrischen Strom umzuwandeln, wobei das Testverfahren mithilfe einer Testvorrichtung (1) nach einem der vorhergehenden Ansprüche durchgeführt wird und die folgenden Schritte umfasst:
- Positionieren (100) der Matrix (10) von Lichtquellen (11) der Testvorrichtung gegenüber dem Solargenerator,
- selektives Beleuchten (200) mindestens einer Solarzelle des Solargenerators in allen Wellenlängenbändern zur Stromumwandlung von jedem Übergang der Solarzelle, durch Einschalten mindestens einer Lichtquelle der Matrix,
- Messen (300) eines Ansprechstroms der beleuchteten Solarzelle, und
- Analysieren (400) des gemessenen Ansprechstroms, um daraus einen fehlerfreien oder fehlerhaften Zustand des Solargenerators abzuleiten.

13. Verfahren nach Anspruch 12, wobei der Solargenerator an einen Satelliten oder eine Solardrohne montiert ist und der gemessene Ansprechstrom ein Versorgungsstrom des Satelliten oder der Solardrohne von dem Solargenerator ist.

14. Verfahren nach einem der Ansprüche 12 oder 13, wobei der Solargenerator an einen Satelliten montiert ist und die Testvorrichtung derart ausgebildet ist, dass alle Solarzellen des Solargenerators gleichzeitig beleuchtet werden können, wobei das Verfahren einen Schritt zum Testen des Einschaltens des Satelliten durch gleichzeitige Beleuchtung aller Solarzellen des Solargenerators umfasst.

15. Verfahren nach einem der Ansprüche 12 bis 14, wobei der Solargenerator eine Vielzahl von Strings (21) von Solarzellen (20) aufweist, wobei die Solarzellen (20) eines Strings (21) in Reihe geschaltet sind,
wobei das Verfahren das Testen von mindestens einem String (21) von Solarzellen umfasst, wobei das Testen umfasst:
- das aufeinanderfolgende Beleuchten (200) von Solarzellengruppen eines Strings, wobei die Gruppen eine konstante Anzahl von Solarzellen aufweisen und die aufeinanderfolgend beleuchteten Gruppen um eine Solarzelle voneinander versetzt sind, und
- Bestimmen (400), in Abhängigkeit von dem Ansprechstrom, der für jede beleuchtete Gruppe von Solarzellen gemessen wird, eines fehlerfreien oder fehlerhaften Zustands der Zellen des Strings und eines fehlerfreien oder fehlerhaften Zustands der elektrischen Kontakte zwischen den Zellen des Strings.

16. Verfahren nach dem vorhergehenden Anspruch, wobei jede Solarzelle des Solargenerators mit einer Bypass-Diode (22) verknüpft ist und das Testen eines Strings (21) von Solarzellen ferner das Bestimmen (400), in Abhängigkeit von dem Ansprechstrom, der für jede beleuchtete Gruppe von Solarzellen gemessen wird, eines fehlerfreien oder fehlerhaften Zustands der Bypass-Dioden (22) umfasst, die mit den Solarzellen (20) des Strings (21) verknüpft sind.

17. Verfahren nach einem der Ansprüche 12 bis 16, wobei der Solargenerator (2) mit einem Regler (25) verbunden ist und eine Vielzahl von Strings (21) von Solarzellen (20) aufweist, wobei die Solarzellen eines Strings in Reihe geschaltet sind, und wobei das Verfahren das selektive Beleuchten (200) von einem oder von mehreren Strings (21) von Solarzellen und das Bestimmen (400), in Abhängigkeit von dem gemessenen Ansprechstrom, eines fehlerfreien oder fehlerhaften Zustands des Reglers und der Verbindungen zwischen den Strings (21) und dem Regler (25) umfasst.

## Claims

1. Device (1) for testing a solar generator (2) of a satellite or solar drone, the solar generator (2) comprising a matrix of single-junction or multi-junction solar cells (20), each junction being adapted to convert photons of a respective wavelength band into electric current, the test device (1) comprising:
- a lighting device (19) adapted to emit light in each of the electric conversion wavelength bands of the junction or junctions of solar cells, the lighting device comprising a matrix (10) of light sources (11), comprising at least one row of light sources (11), each light source (11) of the matrix being adapted to emit light in at least one electric conversion wavelength band of the junction or junctions of solar cells (20),
- a control unit (12) of the matrix (10) of light sources, adapted to control the lighting and the extinction of each of the light sources (11) of the matrix individually,
the matrix (10) of light sources (11) also being configured so as to be able to illuminate selectively each solar cell (20) of the solar generator by lighting one or more light sources (11) of the matrix,
and the lighting device being configured to be able to illuminate each solar cell (20) of the solar generator with a surface light power received by the solar cell higher than at least 130 W/m².

2. Test device (1) according to claim 1, wherein each solar cell (20) is of the multi-junction type, and each light source (11) of the matrix (10) is adapted to emit light in each of the electrical conversion wavelength bands of the junction or junctions of the solar cells (20).

3. Test device (1) according to claim 2, wherein each light source (11) of the matrix (10) comprises a plurality of light-emitting diodes, each light-emitting diode being adapted to emit light in an electric conversion wavelength band of a respective junction of solar cells.

4. Test device (1) according to claim 3, wherein N is the number of junctions of solar cells (20) of the solar generator (2), and wherein each light source (11) of the matrix comprises a number n of light-emitting diodes, each diode of a light source is adapted to emit light in a wavelength band absorbed by a respective junction of solar cells.

5. Test device (1) according to the preceding claim, wherein the solar cells (20) are of the triple junction type, and each light source (11) of the matrix (10) comprises:
- a first light-emitting diode adapted to emit light in a wavelength band centred on 450 nm,
- a second light-emitting diode adapted to emit light in a wavelength band centred on 850 nm, and
- a third light-emitting diode adapted to emit light in a wavelength band centred on 940 nm.

6. Test device (1) according to any of claims 2 to 4, wherein the control unit (12) is also adapted to individually control the lighting, extinction and power of each light-emitting diode from a light source (11) of the matrix.

7. Test device (1) according to claim 1, wherein each solar cell is a multi-junction type of cell, and each light source (11) of the matrix is adapted to emit light in a single electric conversion wavelength band of a junction of solar cells, and the lighting device also comprises at least one secondary light source adapted to emit light in each of the other electric conversion wavelength bands of junctions of solar cells.

8. Test device (1) according to any of the preceding claims, wherein the distance between two adjacent light sources (11) of the matrix is lower than or equal to the distance between the centres of two adjacent solar cells (20).

9. Test device (1) according to any of the preceding claims, also comprising an optical device adapted to control the aperture angle of a light beam emitted by each light source.

10. Test device (1) according to any of the preceding claims, also comprising a protective device (18) of the solar generator, comprising:
- a transparent screen (180) adapted to block the light rays with a wavelength greater than 1.8 µm, and
- a fan (181) adapted to circulate the air between the transparent screen and the matrix of light sources.

11. Test device (1) according to any of the preceding claims, wherein the matrix (10) of light sources (11) is formed by a plurality of submatrices (15), each submatrix (15) comprising at least one row of light sources (11).

12. Method for testing a solar generator (2) of a satellite (S) or a solar drone, the solar generator (2) comprising a matrix of single-junction or multi-junction solar cells (20), each junction being adapted to convert photons of a respective wavelength band into electric current, the testing method being implemented by means of a test device (1) according to any of the preceding claims, and comprising the following steps:
- positioning (100) the matrix (10) of light sources (11) of the test device facing the solar generator,
- by illuminating at least one light source of the matrix, selectively illuminating (200) at least one solar cell of the solar generator in all the electric conversion wavelength bands of each junction of the solar cell,
- measuring (300) a response current of the illuminated solar cell, and
- analysing (400) the measured response current to deduce a healthy or defective state of the solar generator.

13. Method according to claim 12, wherein the solar generator is assembled on a satellite or a solar drone, and the measured response current is a feed current of the satellite or of the solar drone by the solar generator.

14. Method according to any of claims 12 or 13, wherein the solar generator is assembled on a satellite, and the test device is configured in such a way as to be able to simultaneously illuminate all of the solar cells of the solar generator, the method comprising a step of testing the lighting of the satellite by means of the simultaneous illumination of all of the solar cells of the solar generator.

15. Method according to any of claims 12 to 14, wherein the solar generator comprises a plurality of chains (21) of solar cells (20), the solar cells (20) of a chain (21) being connected in series,
the method comprising testing at least one chain (21) of solar cells, said test comprising:
- illuminating (200) successively groups of solar cells of a chain, the groups comprising a constant number of solar cells and the successively illuminated groups being offset from one another by a solar cell, and
- as a function of the response current measured for each group of illuminated solar cells, determining (400) a healthy or defective state of cells of the chain and a healthy or defective state of electric contacts between the cells of the chain.

16. Method according to the preceding claim, wherein each solar cell of the solar generator is associated with a bypass diode (22), and the test of a chain (21) of solar cells also comprises determining (400), as a function of the response current measured for each group of illuminated solar cells, a healthy or defective state of the bypass diodes (22) associated with the solar cells (20) of the chain (21).

17. Method according to any of claims 12 to 16, wherein the solar generator (2) is connected to a regulator (25), and comprises a plurality of chains (21) of solar cells (20), the solar cells of a chain being connected in series, and the method comprises the selective illumination (200) of one or more chains (21) of solar cells, and determining (400), as a function of the measured response current, a healthy or defective state of the regulator and connections between the chains (21) and the regulator (25).
